# EUROPEAN PATENT SPECIFICATION

(11) **EP 4 507 462 B1**
(45) Date of publication and mention of the grant of the patent: **06.05.2026**
(21) Application number: 23820029.9
(22) Date of filing: 26.05.2023
(51) Int. Cl.: H04M 1/02, G06F 1/16, H04M 1/18

(54) **WATERPROOF STRUCTURE AND ELECTRONIC DEVICE COMPRISING SAME**
WASSERDICHTE STRUKTUR UND ELEKTRONISCHE VORRICHTUNG DAMIT
STRUCTURE ÉTANCHE À L'EAU ET DISPOSITIF ÉLECTRONIQUE LA COMPRENANT

(30) Priority: 07.06.2022 KR 20220068993; 05.07.2022 KR 20220082348
(43) Date of publication of application: 12.02.2025
(73) Proprietor: Samsung Electronics Co., Ltd., Suwon-si, Gyeonggi-do 16677 (KR)
(72) Inventor: LEE, Ohhee, Suwon-si, Gyeonggi-do 16677 (KR); YOON, Byounguk, Suwon-si, Gyeonggi-do 16677 (KR)
(74) Representative: Nederlandsch Octrooibureau
(86) International application number: PCT/KR2023/007290
(87) International publication number: WO 2023/239093

(56) References cited:
- CN-A- 113 890 912
- CN-B- 107 395 819
- JP-A- 2010 087 022
- KR-A- 20120 132 977
- KR-A- 20130 088 844
- KR-A- 20180 096 178
- KR-A- 20220 043 665

## Description

### [Technical Field]

The present disclosure relates to a waterproof structure and an electronic device including the same.

### [Background Art]

An electronic device may include a back glass and a decoration part (cam deco). At least a part of the back glass and at least a part of the decoration part may be formed in shapes corresponding to each other and disposed to be spaced apart from each other at a predetermined interval. The electronic device may include a waterproof tape having one surface on which the back glass and the decoration part are at least partially disposed. The waterproof tape may serve to ensure waterproof performance of the electronic device.

The back glass and the decoration part may be at least partially disposed on one surface of the waterproof tape, and a stainless steel (STS) plate may be disposed on the other surface of the waterproof tape. The stainless steel plate may be a reinforcement structure for stably bonding the waterproof tape.

KR 20220043665 discloses a mobile terminal having a waterproof function. The terminal comprises a first housing, a second housing and a decoration part spaced apart from the first housing.

### [Disclosure of Invention]

### [Technical Problem]

A waterproof structure of an electronic device, which uses a waterproof tape and a stainless plate, may require an arrangement space larger than a predetermined reference arrangement space. For example, an arrangement space of about 0.6 mm may be required in a direction from one surface of a decoration part and one surface of a back glass toward the inside of the electronic device. In addition, the waterproof structure of the electronic device, which uses the waterproof tape and the stainless plate, includes the stainless plate having a predetermined thickness, which may increase a weight and material costs of the electronic device.

An electronic device according to an embodiment of the present disclosure may provide a waterproof structure of the electronic device capable of ensuring an arrangement space and reducing a weight and material costs.

### [Solution to Problem]

The invention is defined in the appended claims.

### [Advantageous Effects of Invention]

The electronic device including the waterproof structure according to the embodiment of the present disclosure may increase the arrangement space for the electronic device by reducing the thickness of the bonding member.

The electronic device including the waterproof structure according to the embodiment of the present disclosure may reduce the weight and material costs of the waterproof structure by reducing the thickness and volume of the stainless plate.

### [Brief Description of Drawings]

FIG. 1 is a block diagram of an electronic device in a network environment according to an embodiment.
FIG. 2 is an exploded perspective view illustrating the electronic device including a waterproof structure according to the embodiment of the present disclosure.
FIG. 3 is a view illustrating the electronic device including a decoration part according to the embodiment of the present disclosure.
FIG. 4 is an exploded perspective view illustrating the waterproof structure according to the embodiment of the present disclosure.
FIG. 5 is a view illustrating a plate according to the embodiment of the present disclosure.
FIGS. 6A and 6B are views illustrating the plate and a waterproof member according to the embodiment of the present disclosure.
FIGS. 7A and 7B are views illustrating the plate and the waterproof member according to the embodiment of the present disclosure on a cross-section taken along line A-A in FIG. 6A.
FIGS. 8A, 8B, and 8C are views illustrating the plate, a bonding member, and the waterproof member according to the embodiment of the present disclosure.
FIG. 9 is a perspective view illustrating the decoration part, a first housing, and the waterproof structure according to the embodiment of the present disclosure.
FIG. 10 is a view illustrating the waterproof structure disposed on the decoration part and the first housing according to the embodiment of the present disclosure.
FIG. 11 is a view illustrating the decoration part, the first housing, and the waterproof structure according to the embodiment of the present disclosure on a cross-section taken along line B-B in FIG. 10.
FIGS. 12A and 12B are views illustrating a protruding extension area of the plate and a waterproof extension area of the waterproof member.
FIG. 13 is a view illustrating the decoration part, the first housing, the waterproof structure, and a housing bonding member according to the embodiment of the present disclosure.
FIG. 14 is a view illustrating the decoration part, the first housing, the waterproof structure, and the housing bonding member according to the embodiment of the present disclosure on a cross-section taken along line C-C in FIG. 13.
FIG. 15 are views illustrating the decoration part, the first housing, a second housing, the waterproof structure, and the housing bonding member according to the embodiment of the present disclosure on a cross-section taken along line D-D in FIG. 13.
FIG. 16 is a view illustrating the waterproof structure and the waterproof extension area disposed on the decoration part and the first housing according to the embodiment of the present disclosure.

### [Mode for the Invention]

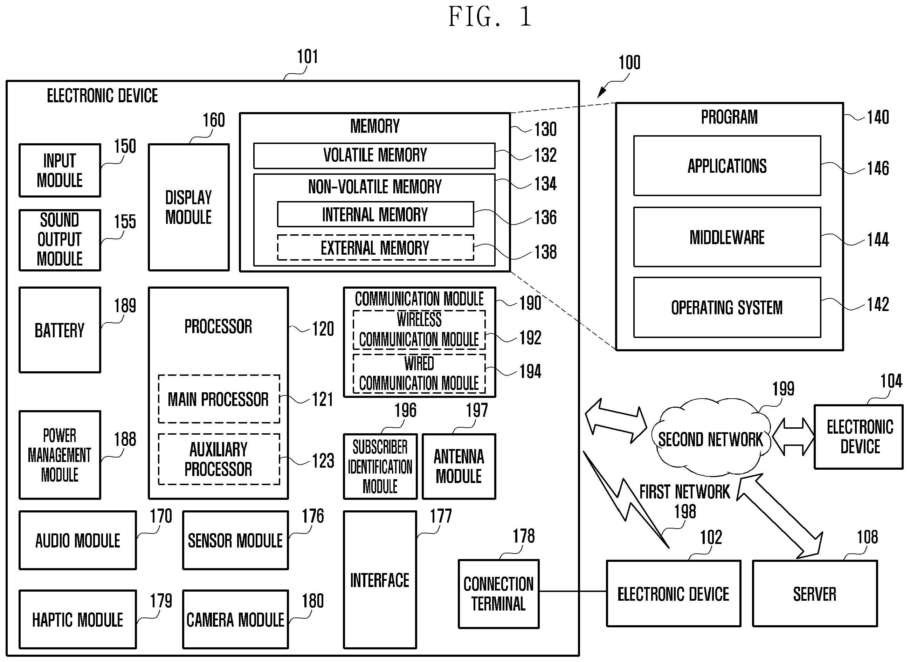

Fig. 1 is a block diagram illustrating an electronic device 101 in a network environment 100 according to various embodiments. Referring to Fig. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module(SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thererto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as BluetoothTM, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or loT-related technology.

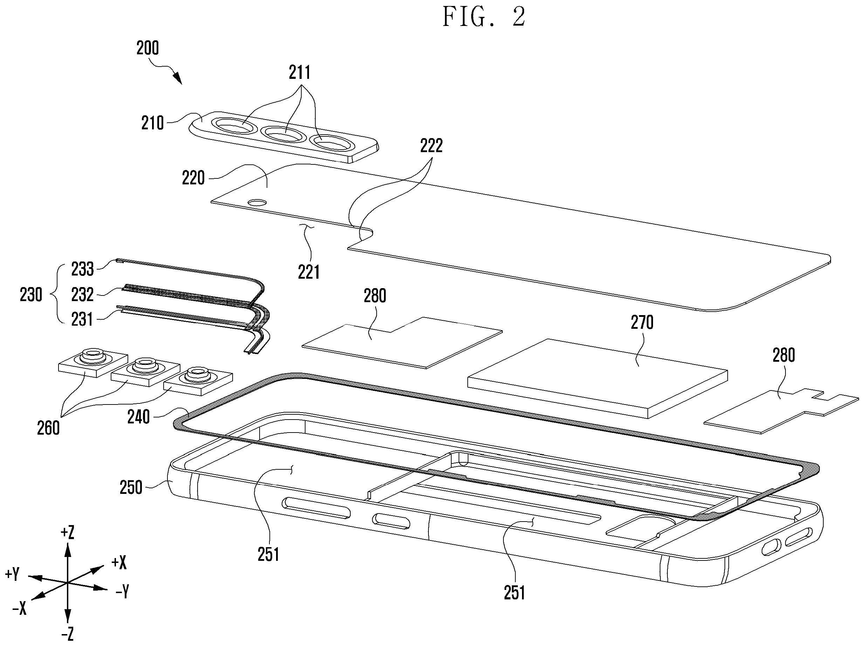

FIG. 2 is an exploded perspective view illustrating an electronic device 200 including a waterproof structure 230 according to an embodiment of the present disclosure.

In the description of the electronic device 200 according to the embodiment of the present disclosure, a width direction of the electronic device 200 may mean an x-axis direction, and a longitudinal direction of the electronic device 200 may mean a y-axis direction. A height direction of the electronic device 200 may mean a z-axis direction.

The electronic device 200 according to the embodiment of the present disclosure may include a decoration part 210, a first housing 220, the waterproof structure 230, a housing bonding member 240, and/or a second housing 250.

In the embodiment, the first housing 220 may include an installation area 221 and/or a boundary area 222.

In the embodiment, the installation area 221 of the first housing 220 may mean an empty space formed in at least a part of the first housing 220. FIG. 2 illustrates that the installation area 221 is formed in one area of the first housing 220 positioned to be close to the first housing 220 in a positive y-axis direction and a negative x-axis direction. However, the position at which the installation area 221 is formed may not be limited thereto.

In the embodiment, the decoration part 210 may be disposed in the installation area 221 of the first housing 220. At least a part of the decoration part 210 may be disposed to be spaced apart from at least a part of the first housing 220. For example, at least a part of the decoration part 210 may be disposed to be spaced apart from the installation area 221 of the first housing 220. For example, the waterproof structure 230 may be disposed between the decoration part 210 and the first housing 220.

In the embodiment, the boundary area 222 of the first housing 220 may be an area formed around the installation area 221 and extending in a longitudinal direction (e.g., the y-axis direction) of the first housing 220 and a width direction (e.g., the x-axis direction) of the first housing 220. The boundary area 222 of the first housing 220 may be formed in a shape corresponding to at least a part of the decoration part 210.

In the embodiment, the decoration part 210 may be a part configured to cover outer sides of camera modules 260 disposed in the electronic device 200. The decoration part 210 may include camera windows 211. For example, the decoration part 210 may be a cover of the camera module 260 including the camera window 211.

In the embodiment, the waterproof structure 230 may include a plate 231, a bonding member 232, and/or a waterproof member 233.

In the embodiment, the plate 231 may extend to correspond to a periphery of the installation area 221 of the first housing 220. For example, the plate 231 may extend in a shape corresponding to the boundary area 222 of the first housing 220.

In the embodiment, the second housing 250 may include an accommodation space 251 in which a printed circuit board 280, a battery 270, and the like, which are disposed in the electronic device 200, are disposed.

In the embodiment, the housing bonding member 240 may extend in a shape corresponding to a periphery of the second housing 250. The decoration part 210 and the first housing 220 may be disposed on one surface of the housing bonding member 240, and the second housing 250 may be disposed on the other surface of the housing bonding member 240. The housing bonding member 240 may serve to bond the first housing 220 and the second housing 250 or bond the decoration part 210 and the second housing 250.

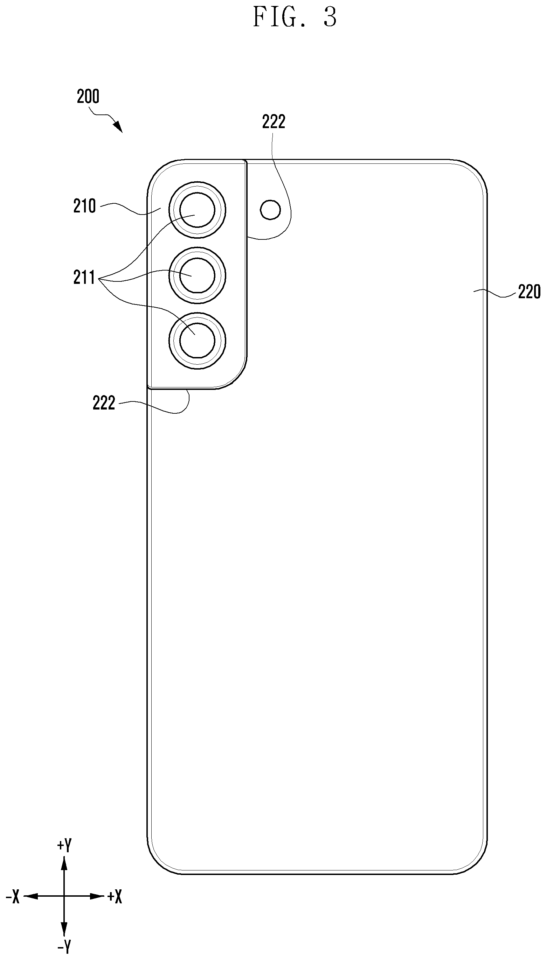

FIG. 3 is a view illustrating the electronic device 200 including the decoration part 210 according to the embodiment of the present disclosure.

In the embodiment, the first housing 220 may be formed in a shape extending in the width direction and the longitudinal direction of the electronic device 200.

In the embodiment, the decoration part 210 may be disposed in at least a part of the first housing 220. For example, the decoration part 210 may be disposed in the installation area 221 (see FIG. 2) of the first housing 220.

In the embodiment, at least a part of the decoration part 210 may be formed in a shape corresponding to the boundary area 222 of the first housing 220. The decoration part 210 may be disposed along the boundary area 222 of the first housing 220.

In the embodiment, the decoration part 210 may include the plurality of camera windows 211. FIG. 3 illustrates that the decoration part 210 includes three camera windows 211. However, the number of camera windows 211 included in the decoration part 210 may not be limited thereto. The camera window 211 may be an area disposed at a position corresponding to the camera module 260 (see FIG. 2), which is positioned in the electronic device 200, and configured to serve as a window that enables the camera module 260 (see FIG. 2) to capture an image of the outside of the electronic device 200.

In the embodiment, the decoration part 210 and the first housing 220 may be disposed at positions at which an outer periphery of the decoration part 210 and an outer periphery of the first housing 220 are consistent with each other in the width direction or the longitudinal direction of the electronic device 200. For example, among the outer peripheries of the decoration part 210, the outer periphery, which is formed in the negative x-axis direction of the decoration part 210 and parallel to the longitudinal direction (e.g., the y-axis direction) of the electronic device 200, may be disposed at the position consistent with at least a part of the outer periphery of the first housing 220 in the width direction (e.g., the x-axis direction) of the electronic device 200.

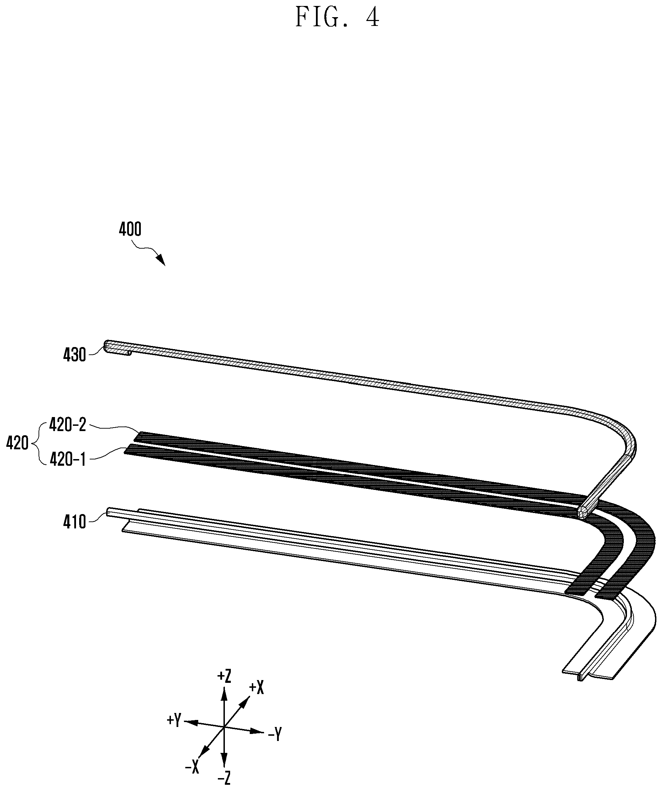

FIG. 4 is an exploded perspective view illustrating a waterproof structure 400 according to the embodiment of the present disclosure.

The waterproof structure 400 illustrated in FIG. 4 may mean the waterproof structure 230 illustrated in FIG. 2 or further include other embodiments of the waterproof structure 230.

In the embodiment, a width direction of the waterproof structure 400 may mean the x-axis direction, and a longitudinal direction of the waterproof structure 400 may mean the y-axis direction. A height direction of the waterproof structure 400 may mean the z-axis direction.

In the embodiment, the width direction, the longitudinal direction, and the height direction of the waterproof structure 400 may respectively mean directions respectively parallel to the width direction, the longitudinal direction, and the height direction of the electronic device 200 (see FIG. 2).

With reference to FIG. 4, the waterproof structure 400 may include a plate 410, a bonding member 420, and/or a waterproof member 430.

The plate 410, the bonding member 420, and the waterproof member 430 illustrated in FIG. 4 may respectively mean the plate 231, the bonding member 232, and the waterproof member 233 illustrated in FIG. 2.

In the embodiment, the bonding member 420 and the waterproof member 430 may be disposed on one surface of the plate 410 (e.g., a surface of the plate 410 directed in the positive z-axis direction).

In the embodiment, the bonding member 420 may include a first bonding member 420-1 and/or a second bonding member 420-2. The first bonding member 420-1 may be a member formed separately from the second bonding member 420-2. The first bonding member 420-1 and the second bonding member 420-2 may be disposed on one surface of the plate 410. At least a part of the first bonding member 420-1 may be positioned in the negative x-axis direction based on the second bonding member 420-2. A length by which the second bonding member 420-2 extends may be longer than a length by which the first bonding member 420-1 extends.

In the embodiment, at least a part of the plate 410 may include an area in which the waterproof member 430 may be disposed. The waterproof member 430 may be disposed on at least a part of the plate 410 and seal at least a part of the electronic device 200, thereby preventing or reducing the introduction of water into the electronic device 200.

In the embodiment, at least a part of the plate 410 may include an area in which the bonding member 420 may be disposed. The plate 410 may be bonded to the decoration part 210 and the first housing 220 by the bonding member 420.

In the embodiment, the waterproof member 430 may include a material having a waterproof effect. For example, the waterproof member 430 may include a liquid silicone rubber (LSR) material having a waterproof effect. In addition, the waterproof member 430 may include a waterproof bonding material having a waterproof effect and bondability.

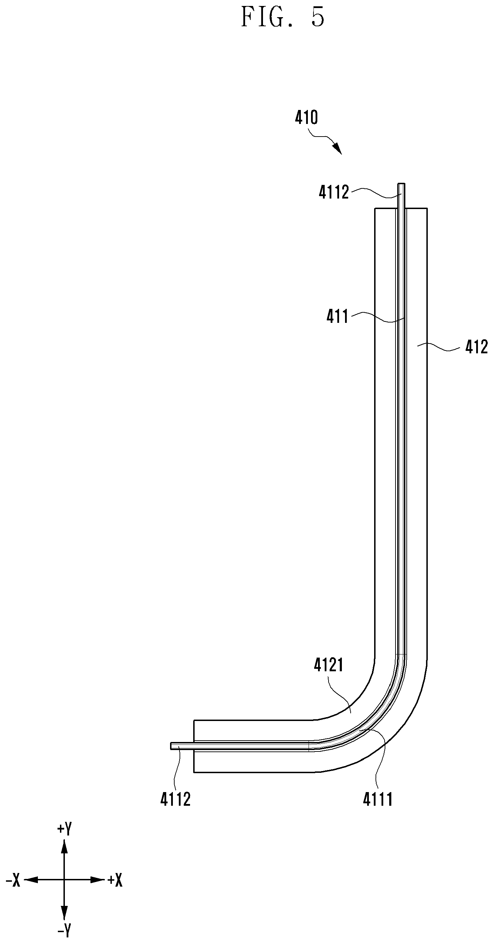

FIG. 5 is a view illustrating the plate 410 according to the embodiment of the present disclosure.

In the embodiment, the plate 410 may extend in the width direction or the longitudinal direction of the electronic device 200 (see FIG. 2). For example, the plate 410 may extend in the longitudinal direction (e.g., the y-axis direction) of the electronic device 200 and then be bent at least partially, and then the plate 410 may extend in the width direction (e.g., the x-axis direction) of the electronic device 200.

In the embodiment, the longitudinal direction of the plate 410 may mean a direction in which the plate 410 extends. For example, with reference to FIG. 5, because the plate 410 extends in the x-axis direction or the y-axis direction, the longitudinal direction of the plate 410 may mean the x-axis direction or the y-axis direction in which the plate 410 extends.

In the embodiment, the plate 410 may include a protruding area 411 and/or flat surface areas 412.

In the embodiment, the protruding area 411 of the plate 410 may be an area formed in a shape formed as at least a part of the plate 410 protrudes in the height direction (e.g., the z-axis direction) of the electronic device 200.

In the embodiment, the flat surface area 412 of the plate 410 may be an area extending from one side and the other side of the protruding area 411. At least a part of the flat surface area 412 may include a surface formed in parallel with the width direction (e.g., the x-axis direction) and the longitudinal direction (e.g., the y-axis direction) of the electronic device 200.

In the embodiment, the protruding area 411 may include a protruding bent area 4111 and/or protruding extension areas 4112. The protruding bent 4111 of the protruding area 411 may be an area in which at least a part of the protruding area 411 is bent from the longitudinal direction (e.g., the y-axis direction) of the electronic device 200 to the width direction (e.g., the x-axis direction) of the electronic device 200.

In the embodiment, the protruding extension area 4112 of the protruding area 411 may mean an area further extending in the longitudinal direction of the plate 410 than a distal end of the flat surface area 412 of the plate 410. For example, the protruding extension areas 4112 of the protruding area 411 may further extend from two distal ends of the plate 410 (e.g., a distal end of the plate 410 directed in the positive y-axis direction and a distal end of the plate 410 directed in the negative x-axis direction) than the flat surface area 412 of the plate 410 in the direction in which the plate 410 extends.

In the embodiment, the protruding extension areas 4112 of the protruding area 411 may be respectively positioned at the two distal ends of the protruding area 411 (e.g., a distal end of the protruding area 411 directed in the positive y-axis direction and a distal end of the protruding area 411 directed in the negative x-axis direction).

In the embodiment, the flat surface area 412 may include a flat surface bent area 4121. The flat surface bent area 4121 may be an area formed in a part of the flat surface area 412. The flat surface bent area 4121 may be an area that extends in the longitudinal direction of the electronic device 200, is bent at least partially, and then extends in the width direction of the electronic device 200.

In the embodiment, at least a part of the flat surface bent area 4121 may be formed as a curved surface. For example, a side surface directed in the positive y-axis direction or the negative x-axis direction based on the flat surface bent area 4121 may be formed as a curved surface.

In the embodiment, the plate 410 may include a stainless steel (STS) material.

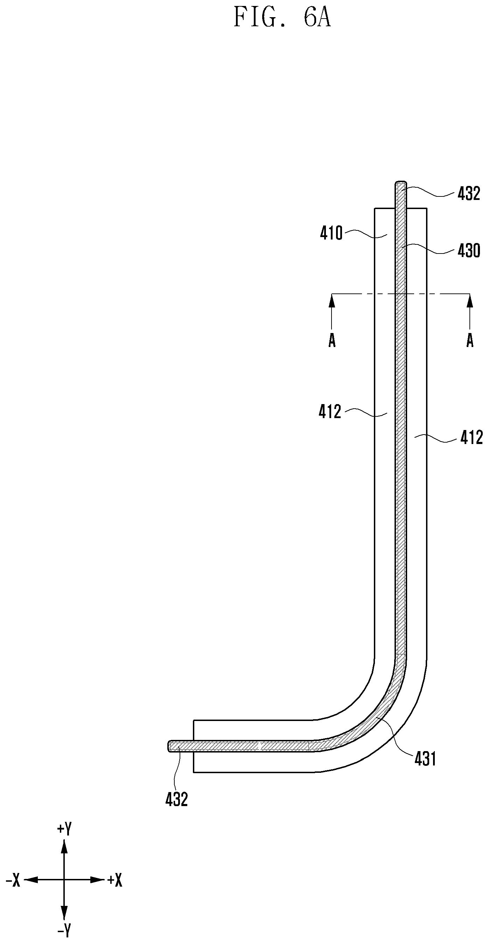

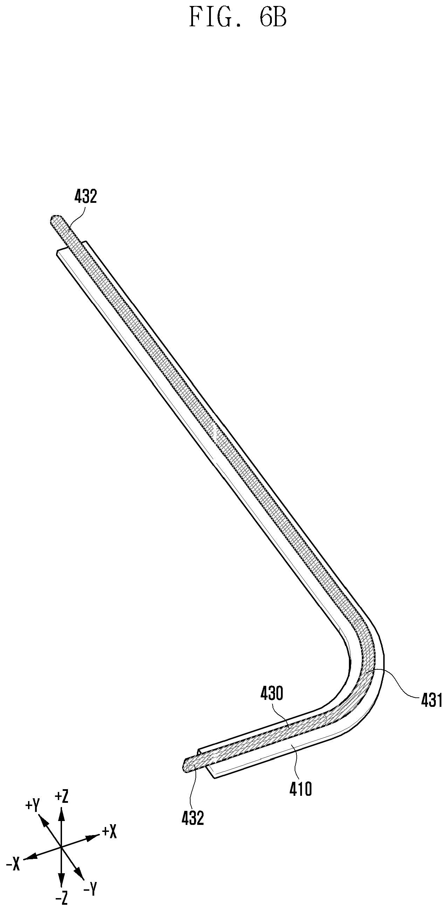

FIGS. 6A and 6B are views illustrating the plate 410 and the waterproof member 430 according to the embodiment of the present disclosure.

With reference to FIGS. 5, 6A, and 6B, the waterproof member 430 may be disposed along the protruding area 411 of the plate 410. For example, the waterproof member 430 may cover at least a part of the protruding area 411 and be disposed in the direction in which the protruding area 411 extends.

In the embodiment, the waterproof member 430 may be disposed by being applied onto at least a part of the protruding area 411 of the plate 410.

In the embodiment, the waterproof member 430 may include a waterproof bent area 431 and/or waterproof extension areas 432. The waterproof bent area 431 may mean one area of the waterproof member 430 disposed along the protruding bent area 4111 of the protruding area 411. The waterproof extension area 432 may mean one area of the waterproof member 430 disposed along the protruding extension area 4112 of the protruding area 411.

In the embodiment, the waterproof extension area 432 of the waterproof member 430 may be an area formed as at least a part of the waterproof member 430 further extends in the longitudinal direction of the plate 410 than the flat surface area 412 of the plate 410.

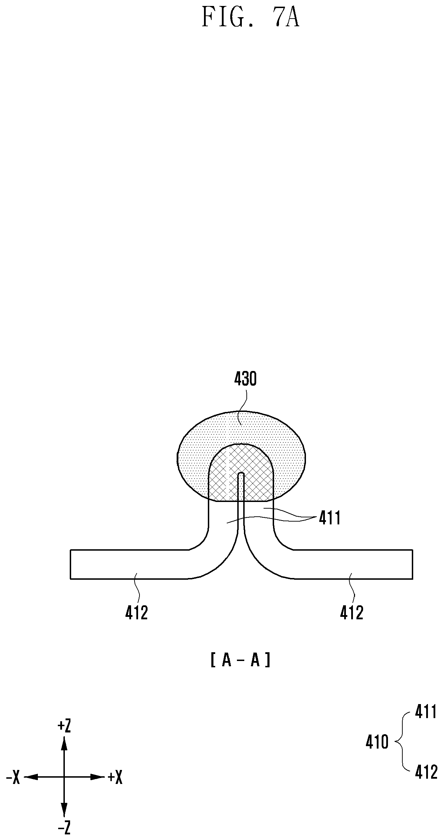

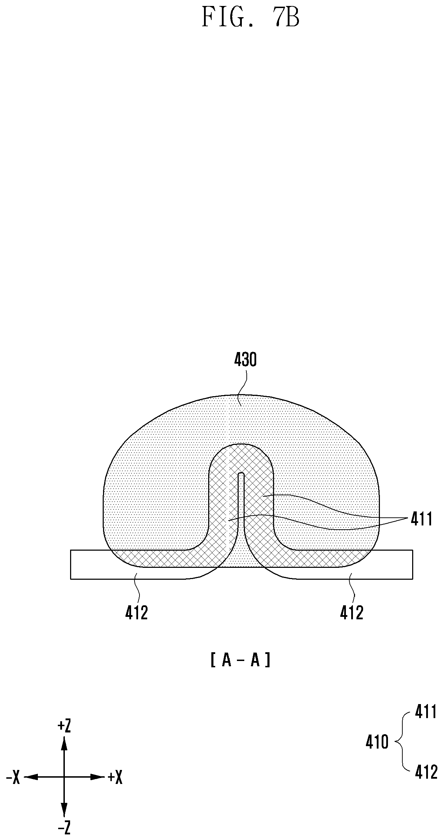

FIGS. 7A and 7B are views illustrating the plate 410 and the waterproof member 430 according to the embodiment of the present disclosure on a cross-section taken along line A-A in FIG. 6A.

In the embodiment, the height direction of the plate 410 may mean the z-axis direction.

With reference to FIGS. 7A and 7B, the waterproof member 430 may be disposed in the protruding area 411 of the plate 410.

In the embodiment, at least a part of the waterproof member 430 may be disposed in at least a part of the protruding area 411 of the plate 410. For example, with reference to FIG. 7A, at least a part of the waterproof member 430 may be disposed at the distal end of the protruding area (e.g., the distal end directed in the positive z-axis direction).

In the invention, the protruding area 411 of the plate 410 is an area further protruding in the height direction (e.g., positive z-axis direction) of the plate 410 than the flat surface area 412 of the plate 410.

In the embodiment, the protruding area 411 of the plate 410 may be formed while being bent at least partially. For example, a part of the protruding area 411 may extend in the positive z-axis direction and then be bent in the opposite direction (e.g., the negative z-axis direction). The remaining part of the protruding area 411 may extend in the negative z-axis direction.

In the embodiment, the flat surface area 412 may be formed in one direction and the other direction of the protruding area 411. For example, the flat surface area 412 may extend from the protruding area 411 in the negative x-axis direction. The flat surface area 412 may extend from the protruding area 411 in the positive x-axis direction.

In the embodiment, the protruding area 411 may be an area formed as at least a part of the flat surface area 412 of the plate 410 is bent. For example, the protruding area 411 may be formed as a part of the flat surface area 412 is bent in the height direction (e.g., the z-axis direction) of the plate 410.

In the embodiment, the protruding area 411 and the flat surface area 412 of the plate 410 may be areas manufactured separately. For example, FIGS. 7A and 7B illustrate that the protruding area 411 extends from the flat surface area 412. However, the protruding area 411 may be manufactured separately from the flat surface area 412 and then joined to the flat surface area 412.

In the embodiment, one surface of the flat surface area 412 may mean a surface of the flat surface area 412 directed in a direction perpendicular to the positive z-axis direction. The other surface of the flat surface area 412 may mean a surface of the flat surface area 412 directed in a direction perpendicular to the negative z-axis direction.

With reference to FIG. 7B, at least a part of the waterproof member 430 according to the embodiment may be disposed to cover at least a part of the flat surface area 412 of the plate 410 while surrounding the protruding area 411. For example, with reference to FIG. 7B, at least a part of the waterproof member 430 may be disposed to cover at least a part of one surface of the flat surface area 412 of the plate 410. FIG. 7B illustrates that the waterproof member 430 is disposed on a part of one surface of the flat surface area 412. However, the arrangement of the waterproof member 430 is not limited thereto. The waterproof member 430 may be disposed on the entirety of one surface of the flat surface area 412.

In the embodiment, at least a part of the waterproof member 430 may be disposed to cover the entirety of the flat surface area 412 of the plate 410 while surrounding the protruding area 411. For example, unlike the arrangement of the waterproof member 430 illustrated in FIGS. 7A and 7B, the waterproof member 430 according to the embodiment may be disposed to cover both one surface of the flat surface area 412 and the other surface of the flat surface area 412.

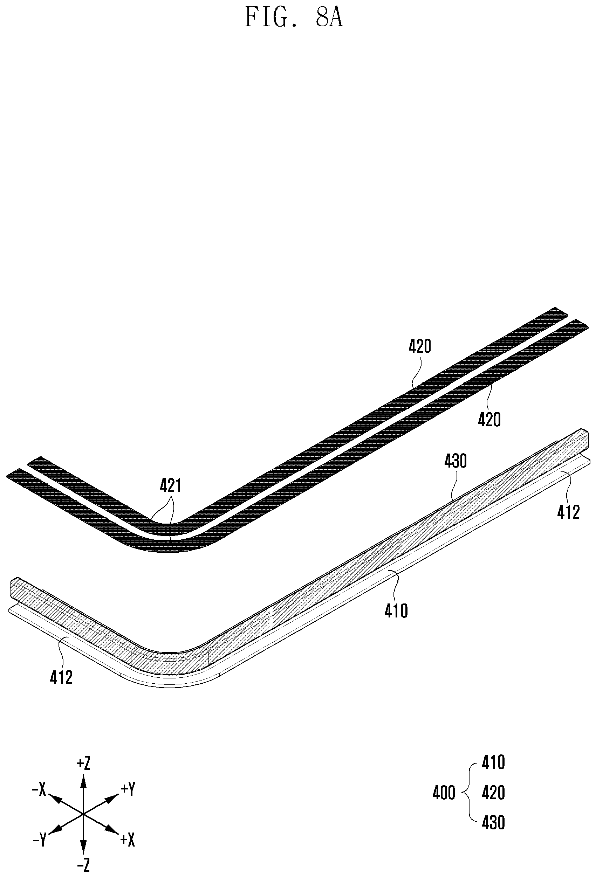

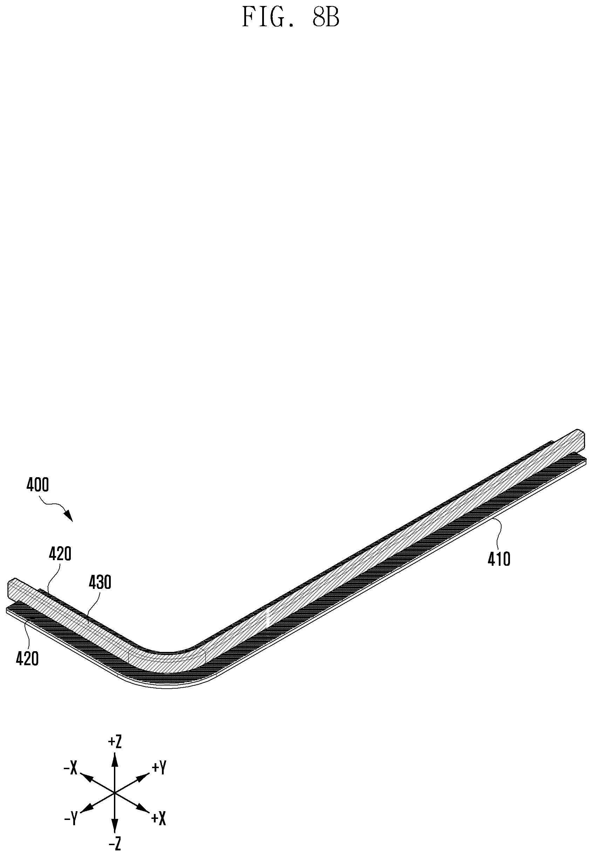

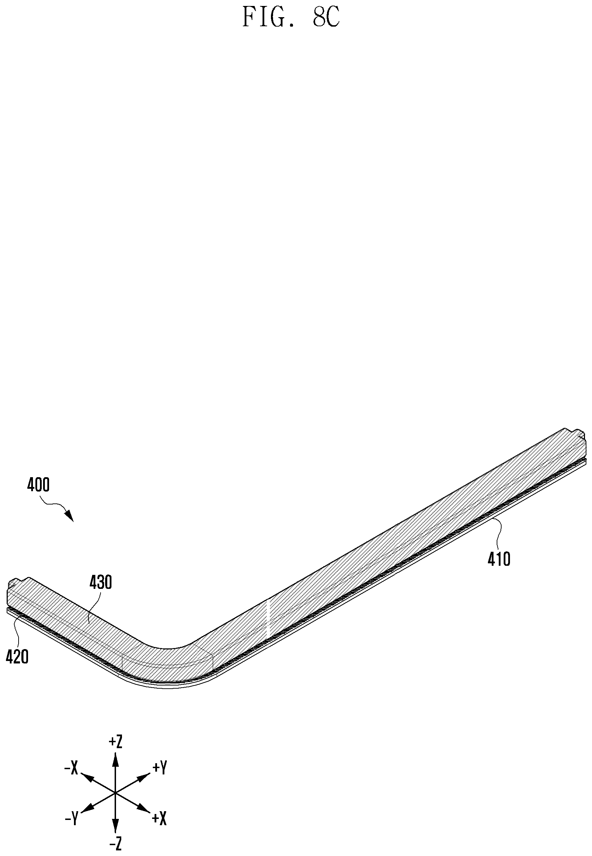

FIGS. 8A, 8B, and 8C are views illustrating the plate 410, the bonding member 420, and the waterproof member 430 according to the embodiment of the present disclosure.

In the embodiment, the bonding member 420 may extend in the width direction (e.g., the x-axis direction) of the waterproof structure 400 and the longitudinal direction (e.g., the y-axis direction) of the waterproof structure 400. For example, the bonding member 420 may extend in the width direction of the waterproof structure 400 and be bent at least partially, and then the bonding member 420 may extend in the longitudinal direction of the waterproof structure 400.

In the embodiment, the bonding member 420 may include a bonding bent area 421. The bonding member 420 may extend while the bonding bent area 421 is bent from the width direction of the waterproof structure 400 to the longitudinal direction of the waterproof structure 400.

In the embodiment, the bonding member 420 may be disposed on at least a part of the plate 410. For example, with reference to FIGS. 8A and 8B, the bonding member 420 may be disposed on one surface of the flat surface area 412 of the plate 410 (e.g., the surface of the flat surface area 412 directed in the direction perpendicular to the positive z-axis direction).

In the embodiment, the waterproof structure 400 may include the plurality of bonding members 420.

With reference to FIG. 8A, two bonding members 420 may be provided. The two bonding members 420 may be respectively disposed in the flat surface areas 412 of the plate 410. One bonding member 420 may be formed to be longer than the remaining bonding member 420. For example, one bonding member 420 may be further elongated than the remaining bonding member 420 in the width direction and the longitudinal direction of the waterproof structure 400.

In the embodiment, the bonding member 420 may include a bondable material. For example, the bondable material may include at least one of an epoxy bonding agent, an acrylic bonding agent, a silicone bonding agent, and/or a urethane bonding agent. The bonding member 420 including a bondable material may bond at least a part of the plate 410 to the decoration part 210 (see FIG. 2) and the first housing 220 (see FIG. 2).

In the embodiment, the bonding member 420 may include a waterproof material. For example, the bonding member 420 may include at least one of waterproof dispensing, waterproof rubber, sponge, urethane, and silicone. In case that the bonding member 420 includes a waterproof material, the bonding member 420 may serve to seal at least a part of a space defined between the plate 410, the decoration part 210 (see FIG. 2), and the first housing 220 (see FIG. 2).

With reference to FIG. 8C, at least a part of the waterproof member 430 according to the embodiment may be disposed to cover at least a part of the flat surface area 412 of the plate 410 while surrounding the protruding area 411. For example, at least a part of the waterproof member 430 may be disposed to cover at least a part of one surface of the flat surface area 412 of the plate 410.

In the embodiment, in case that the waterproof member 430 is disposed to cover at least a part of the flat surface area 412, the waterproof member 430 may be disposed to be in contact with at least a part of the bonding member 420 disposed on one surface of the flat surface area 412. For example, the flat surface area 412, the bonding member 420, and the waterproof member 430 may be sequentially disposed in the height direction (e.g., the z-axis direction) of the waterproof structure 400, and the waterproof member 430 and the bonding member 420 may be in contact with each other.

In the embodiment, in case that the waterproof member 430 is disposed to cover at least a part of the flat surface area 412, the waterproof member 430 may be disposed on one surface of the flat surface area 412 and be in contact with at least a part of the bonding member 420. For example, the flat surface area 412, the waterproof member 430, and the bonding member 420 may be sequentially disposed in the height direction (e.g., the z-axis direction) of the waterproof structure 400, and the waterproof member 430 and the bonding member 420 may be in contact with each other.

In the embodiment, at least a part of the waterproof member 430 may be disposed to cover the entirety of the flat surface area 412 of the plate 410 while surrounding the protruding area 411. For example, unlike the arrangement of the waterproof member 430 illustrated in FIGS. 8B and 8C, the waterproof member 430 according to the embodiment may be disposed to cover both one surface of the flat surface area 412 and the other surface of the flat surface area 412.

In the embodiment, in case that the waterproof member 430 is disposed to cover both one surface and the other surface of the flat surface area 412, the waterproof member 430 may be disposed to be in contact with the entirety of the bonding member 420 disposed on one surface of the flat surface area 412, or the waterproof member 430 may be disposed on one surface of the flat surface area 412 and be in contact with the bonding member 420. For example, the flat surface area 412, the bonding member 420, and the waterproof member 430 may be sequentially disposed or the flat surface area 412, the waterproof member 430, and the bonding member 420 may be sequentially disposed in the height direction (e.g., the z-axis direction) of the waterproof structure 400, and the waterproof member 430 and the bonding member 420 may be in contact with each other.

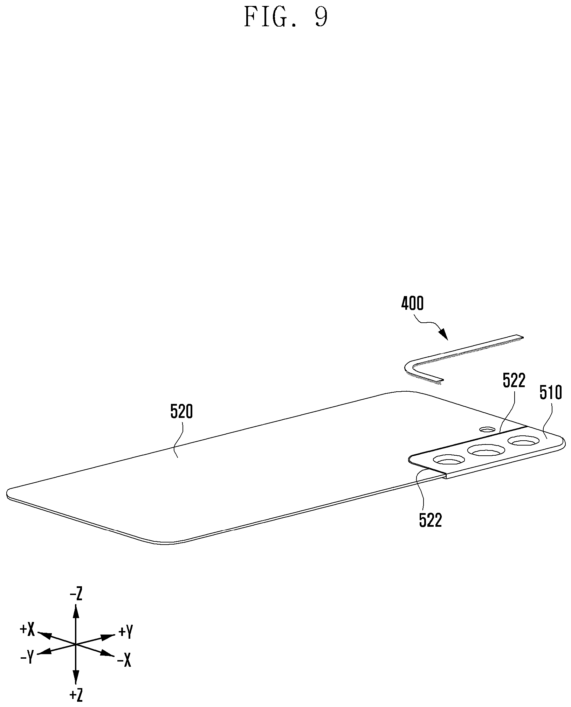

FIG. 9 is a perspective view illustrating a decoration part 510, a first housing 520, and the waterproof structure 400 according to the embodiment of the present disclosure.

The decoration part 510 illustrated in FIG. 9 may mean the decoration part 210 illustrated in FIG. 2 or further include other embodiments of the decoration part 210. The first housing 520 illustrated in FIG. 9 may mean the first housing 220 illustrated in FIG. 2 or further include other embodiments of the first housing 220.

The waterproof structure 400 illustrated in FIG. 9 may be the waterproof structure 400 including the bonding member 420 illustrated in FIGS. 8A and 8B. For example, the waterproof structure 400 illustrated in FIG. 9 may be in a state in which the bonding member 420 (see FIG. 8) bonded to a part of the waterproof structure 400.

FIG. 9 may be a view illustrating a state made before the waterproof structure 400 is disposed on the decoration part 510 and the first housing 520. In the state illustrated in FIG. 9, the waterproof structure 400 may move in the direction (e.g., the positive z-axis direction) toward the decoration part 510 and the first housing 520. The waterproof structure 400 may be disposed to be in contact with at least a part of the decoration part 510 and at least a part of the first housing 520.

In the embodiment, the waterproof structure 400 may be disposed in one direction of the first housing 520 and the decoration part 510. For example, the waterproof structure 400 may be disposed in the negative z-axis direction based on the first housing 520 and the decoration part 510.

In the embodiment, at least a part of the first housing 520 may include a boundary area 522. The boundary area 522 may be an area of the outer periphery of the first housing 520 positioned to be spaced apart from the decoration part 510. The decoration part 510 may be positioned to be spaced apart from one side of the boundary area 522.

In the embodiment, at least a part of the boundary area 522 of the first housing 520 may be in contact with at least a part of the decoration part 510. For example, a part of the decoration part 510 may be in contact with the boundary area 522 of the first housing 520, and the remaining part of the decoration part 510 may be positioned to be spaced apart from the boundary area 522 of the first housing 520.

In the embodiment, at least a part of the waterproof structure 400 may be disposed in the boundary area 522 of the first housing 520 and disposed on the decoration part 510 positioned to be spaced apart from one side of the boundary area 522.

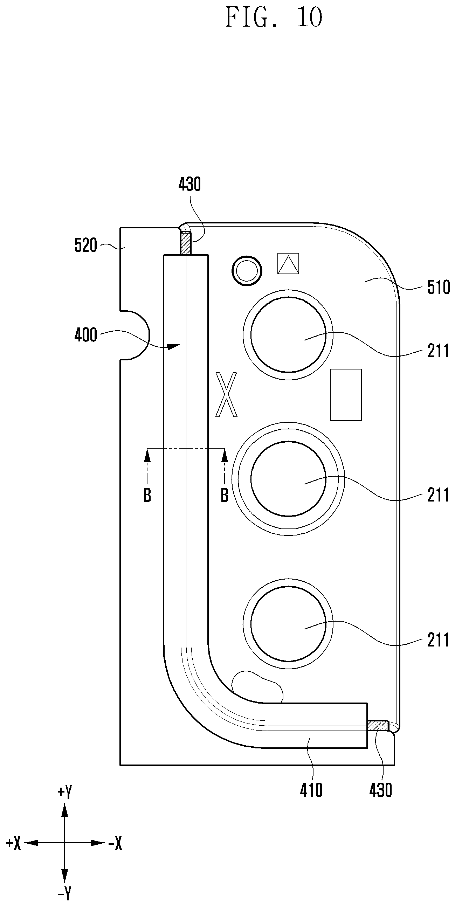

FIG. 10 is a view illustrating the waterproof structure 400 disposed on the decoration part 510 and the first housing 520 according to the embodiment of the present disclosure.

In the embodiment, one side of the waterproof member 430 may mean a side surface positioned in the positive x-axis direction or the negative y-axis direction based on the waterproof member 430, and the other side of the waterproof member 430 may mean a side surface positioned in the negative x-axis direction or the positive y-axis direction based on the waterproof member 430.

In the invention, the first housing 520 is disposed at one side of the waterproof member 430. The decoration part 510 may be disposed at the other side of the waterproof member 430.

In the embodiment, at least a part of the waterproof member 430 may further extend than the distal end of the plate 410. For example, the waterproof member 430 may further extend from the distal end of the waterproof member 430 directed in the positive y-axis direction or the distal end of the waterproof member 430 directed in the negative x-axis direction than the plate 410 in the positive y-axis direction or the negative x-axis direction.

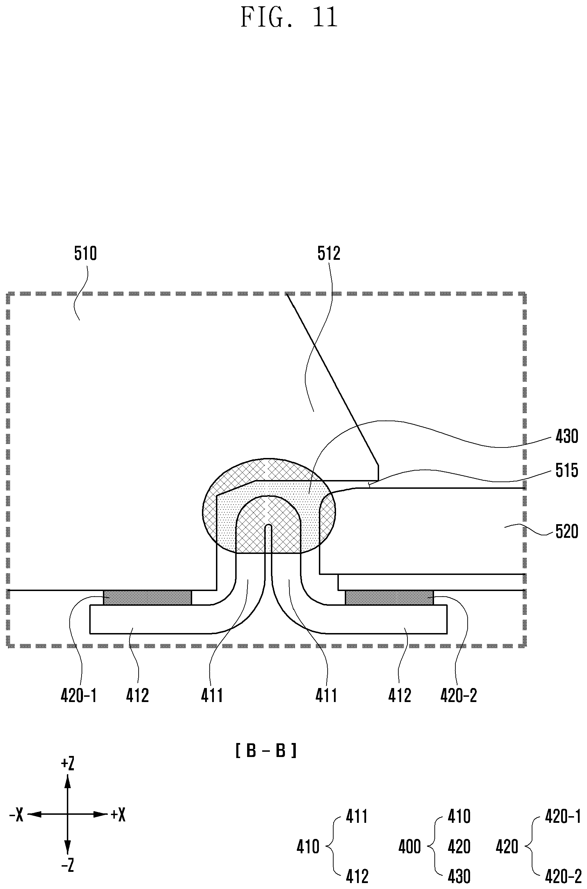

FIG. 11 is a view illustrating the decoration part 510, the first housing 520, and the waterproof structure 400 according to the embodiment of the present disclosure on a cross-section taken along line B-B in FIG. 10.

In the embodiment, the bonding member 420 may be disposed in the flat surface area 412 of the plate 410. For example, the bonding member 420 may be disposed in the positive z-axis direction based on the flat surface area 412 of the plate 410.

In the embodiment, the bonding member 420 may include the first bonding member 420-1 and/or the second bonding member 420-2. The first bonding member 420-1 may be a member formed separately from the second bonding member 420-2. The first bonding member 420-1 and the second bonding member 420-2 may be respectively disposed in the flat surface areas 412 of the plate 410. For example, the first bonding member 420-1 may be disposed in the flat surface area 412 of the plate 410 positioned in the negative x-axis direction based on the protruding area 411 of the plate 410. The second bonding member 420-2 may be disposed in the flat surface area 412 of the plate 410 positioned in the positive x-axis direction based on the protruding area 411 of the plate 410.

In the embodiment, the first bonding member 420-1 may be in contact with the decoration part 510 on one surface of the first bonding member 420-1. The second bonding member 420-2 may be in contact with the first housing 520 on one surface of the second bonding member 420-2. In the embodiment, the two bonding members 420 may be disposed on the plate 410. For example, one bonding member 420 may be disposed in one direction of the protruding area 411 of the plate 410 (e.g., the negative x-axis direction based on the protruding area 411), and the remaining bonding member 420 may be disposed in the other direction of the protruding area 411 of the plate 410 (e.g., the positive x-axis direction based on the protruding area 411).

In the embodiment, one surface of the bonding member 420 may mean a surface directed in the direction perpendicular to the negative z-axis direction based on the bonding member 420. The other surface of the bonding member 420 may mean a surface directed in the direction perpendicular to the positive z-axis direction based on the bonding member 420.

In the embodiment, the flat surface area 412 of the plate 410 may be disposed on one surface of one bonding member 420, and the decoration part 510 may be disposed on the other surface of one bonding member 420. The flat surface area 412 of the plate 410 may be disposed on one surface of the remaining bonding member 420, and the first housing 520 may be disposed on the other surface of the remaining bonding member 420.

In the embodiment, a thickness of the bonding member 420 (e.g., a length of the bonding member 420 in the z-axis direction) may be about 0.05 mm to 0.5 mm. For example, the thickness of the bonding member 420 may be about 0.2 mm. The thickness of the bonding member 420 may be smaller than a thickness of the housing bonding member 240 (see FIG. 2).

In the embodiment, a thickness of the flat surface area 412 of the plate 410 (e.g., a length of the flat surface area 412 of the plate 410 in the z-axis direction) may be about 0.05 mm to 0.3 mm. For example, the thickness of the flat surface area 412 of the plate 410 may be about 0.1 mm.

In the embodiment, the plate 410 may be supported by at least one internal structure (not illustrated) positioned in the electronic device 200 (see FIG. 2), or the plate 410 may be positioned to be spaced apart from the internal structure (not illustrated).

In the embodiment, at least a part of the decoration part 510 may be disposed in one direction of the protruding area 411, and at least a part of the first housing 520 may be disposed in the other direction of the protruding area 411.

In the embodiment, the decoration part 510 may include a decoration part extension area 512 formed as at least a part of the decoration part 510 extends in one direction (e.g., the positive x-axis direction) of the decoration part 510. For example, the decoration part extension area 512 may be an area formed as at least a part of the decoration part 510 extends in the positive x-axis direction. The decoration part extension area 512 may be positioned in the positive z-axis direction based on the protruding area 411 of the plate 410.

In the embodiment, the decoration part extension area 512 may be positioned to be spaced apart from the protruding area 411 and at least a part of the first housing 520 in the height direction (e.g., the z-axis direction) of the waterproof structure 400. For example, the decoration part extension area 512 may be positioned to be spaced apart from the protruding area 411 in the positive z-axis direction and positioned to be spaced apart from one surface of the first housing 520 in the positive z-axis direction. Because the decoration part extension area 512 is positioned to be spaced apart from one surface of the first housing 520, a separation space 515 may be defined between the decoration part extension area 512 and the first housing 520. The separation space 515 may be a passageway through which water may move.

In the embodiment, at least a part of the waterproof member 430 may be disposed on the protruding area 411, the decoration part 510, and the first housing 520. For example, the waterproof member 430 may be disposed at the distal end of the protruding area 411 (e.g., the distal end of the protruding area 411 directed in the positive z-axis direction), one area of the decoration part 510 (e.g., the area of the decoration part 510 positioned adjacent to the protruding area 411), and one side of the first housing 520 (e.g., the side surface positioned in the negative x-axis direction based on the first housing 520).

In the embodiment, the waterproof member 430 may serve to seal at least a part of the space defined between the first housing 520 and the decoration part 510. For example, the waterproof member 430 may serve to seal at least a part of the separation space 515 and prevent or reduce a situation in which water moving through the separation space 515 is introduced into the electronic device 200 (see FIG. 2).

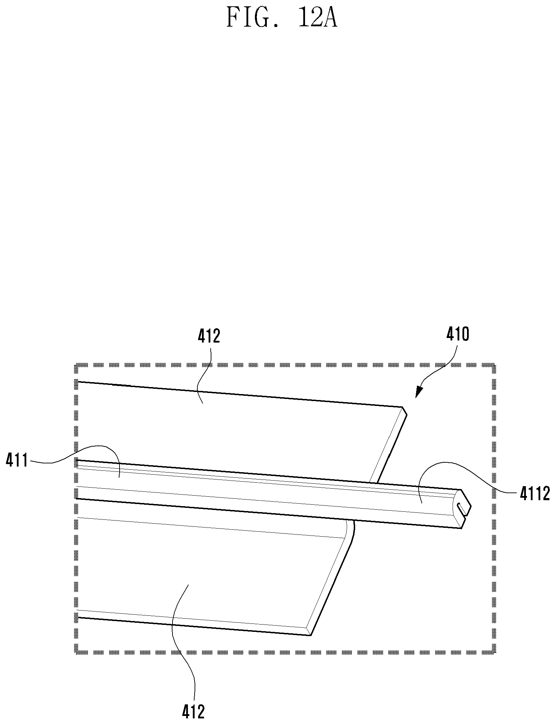

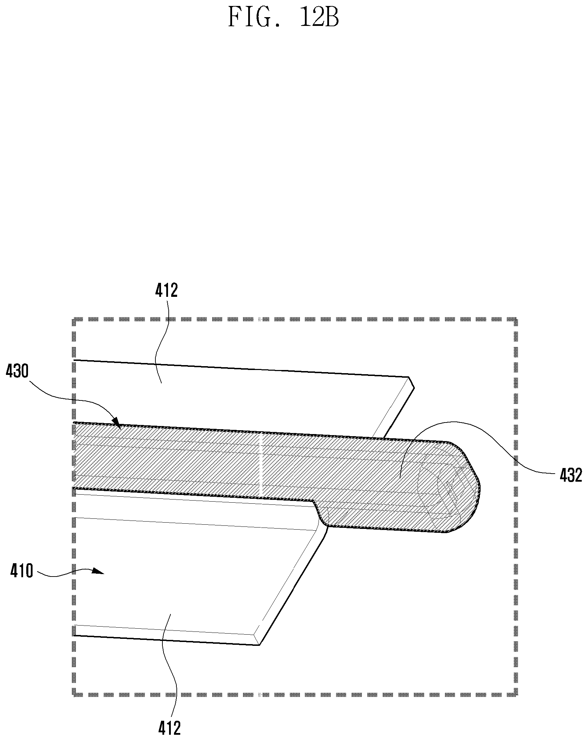

FIGS. 12A and 12B are views illustrating the protruding extension area 4112 of the plate 410 and the waterproof extension area 432 of the waterproof member 430.

FIG. 12A is a view illustrating the protruding extension area 4112 of the plate 410 according to the embodiment of the present disclosure.

FIG. 12B is a view illustrating the waterproof extension area 432 of the waterproof member 430 according to the embodiment of the present disclosure.

The plate 410 includes the flat surface area 412, and the protruding area 411 protruding from one surface of the flat surface area 412 and extending in the longitudinal direction of the plate 410.

In the embodiment, at least a part of the protruding area 411 may further extend in the longitudinal direction of the plate 410 than the flat surface area 412. For example, the protruding area 411 may include the protruding extension area 4112 at the distal end of the protruding area 411, and the protruding extension area 4112 may be an area further extending in the longitudinal direction of the plate 410 than the flat surface area 412.

With reference to FIG. 12A, at least a part of the protruding extension area 4112 of the protruding area 411 may include a bent shape. For example, the protruding extension area 4112 may at least partially extend in a direction away from the flat surface area 412 and then be bent at least partially, and then the protruding extension area 4112 may extend in a direction toward the flat surface area 412. In case that the protruding extension area 4112 includes the bent shape, at least a part of the protruding extension area 4112 may be disposed in two layers in the width direction of the plate 410.

FIG. 12A illustrates that at least a part of the protruding extension area 4112 of the protruding area 411 includes the bent shape. However, the shape of the protruding extension area 4112 may not be limited thereto. For example, the protruding extension area 4112 does not include the bent and extending portion, and the protruding extension area 4112 may extend in a direction perpendicularly away from the flat surface area 412 of the plate 410. In case that the protruding extension area 4112 does not include the bent and extending portion, the protruding extension area 4112 may extend in one layer, unlike the protruding extension area 4112 formed in two layers illustrated in FIG. 12A. The protruding extension area 4112 may be connected to the protruding area 411 of the plate 410 and further extend in the longitudinal direction of the plate 410 than the flat surface area 412.

In the embodiment, the waterproof member 430 may be disposed along the protruding area 411. For example, the waterproof member 430 may cover at least a part of the protruding area 411 and be disposed in the protruding area 411 in the direction in which the protruding area 411 extends.

In the embodiment, the waterproof member 430 may be disposed in the protruding extension area 4112 of the protruding area 411. For example, the waterproof extension area 432 of the waterproof member 430 may be disposed in the protruding extension area 4112 of the protruding area 411. The waterproof extension area 432 may further extend in the longitudinal direction of the plate 410 than the flat surface area 412 of the plate 410 and be disposed in the protruding extension area 4112 of the protruding area 411.

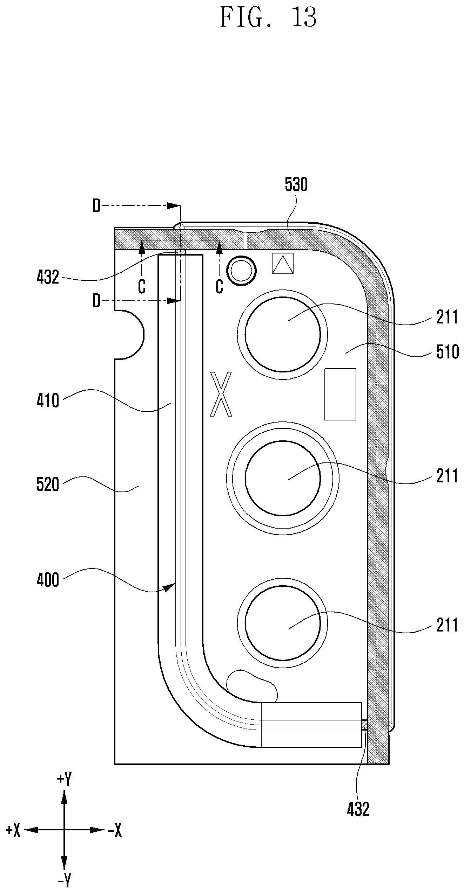

FIG. 13 is a view illustrating the decoration part 510, the first housing 520, the waterproof structure 400, and a housing bonding member 530 according to the embodiment of the present disclosure.

In the embodiment, the housing bonding member 530 may mean the housing bonding member 240 illustrated in FIG. 2 or further include other embodiments of the housing bonding member 240.

With reference to FIG. 13, the housing bonding member 530 may be disposed along a periphery of the decoration part 510 and a periphery of the first housing 520. For example, the housing bonding member 530 may have a predetermined width and extend along at least a part of an outer periphery of the decoration part 510 and at least a part of an outer periphery of the first housing 520.

In the embodiment, the housing bonding member 530 may serve to bond at least a part of the decoration part 510 and at least a part of the first housing 520 to at least a part of the second housing 250 (see FIG. 2).

In the embodiment, the housing bonding member 530 may include a bondable material and a waterproof material. For example, the bondable material included in the housing bonding member 530 may include at least one of an epoxy bonding agent, an acrylic bonding agent, a silicone bonding agent, and/or a urethane bonding agent. The waterproof material included in the housing bonding member 530 may include at least one of waterproof dispensing, waterproof rubber, sponge, urethane, and silicone.

In the embodiment, the housing bonding member 530 may include a waterproof material and serve to at least partially seal the decoration part 510, the first housing 520, and the second housing 250 (see FIG. 2).

In the embodiment, the waterproof extension areas 432 of the waterproof structure 400 may be positioned at the distal ends of the waterproof structure 400. The distal ends of the waterproof structure 400 may include the distal end of the waterproof structure 400 directed in the positive y-axis direction, and the distal end of the waterproof structure 400 directed in the negative x-axis direction. The areas in which the distal ends of the waterproof structure 400 are positioned may be areas of the periphery of the decoration part 510 and the periphery of the first housing 520 where the decoration part 510 and the first housing 520 are disposed to be spaced apart from each other while facing each other.

In the embodiment, at least a part of the housing bonding member 530 and at least a part of the waterproof structure 400 may be disposed to overlap each other. For example, at least a part of the waterproof extension area 432 of the waterproof member 430 positioned at the distal end of the plate 410 may be positioned at a position that overlaps at least a part of the housing bonding member 530.

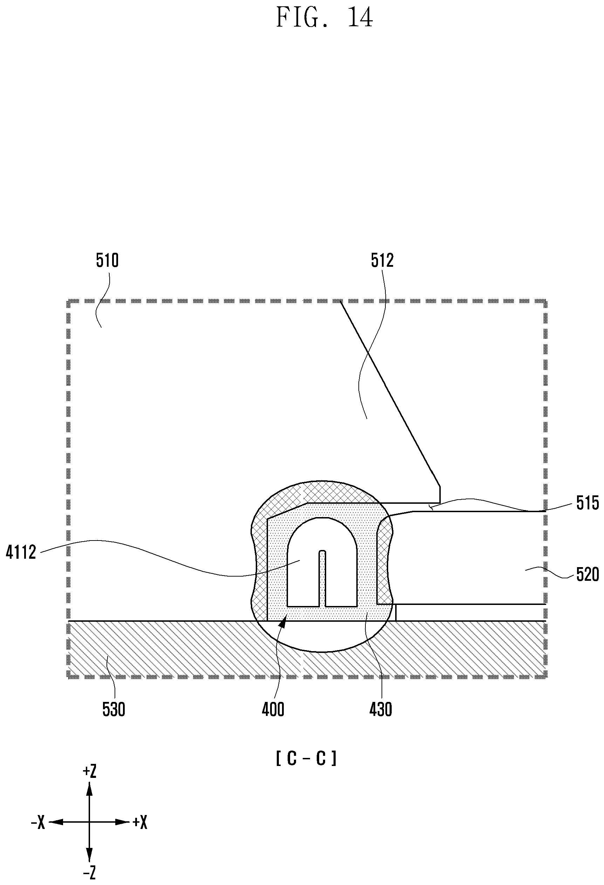

FIG. 14 is a view illustrating the decoration part 510, the first housing 520, the waterproof structure 400, and the housing bonding member 530 according to the embodiment of the present disclosure on a cross-section taken along line C-C in FIG. 13.

In the embodiment, one surface of the housing bonding member 530 may mean a surface directed in the direction perpendicular to the positive z-axis direction based on the housing bonding member 530.

In the embodiment, the decoration part 510, the first housing 520, and the waterproof structure 400 may be disposed on one surface of the housing bonding member 530.

In the embodiment, at least a part of the waterproof structure 400 may be disposed between the decoration part 510 and the first housing 520. For example, the decoration part 510 may be disposed in one direction of the protruding extension area 4112 of the waterproof structure 400. The first housing 520 may be disposed in the other direction of the protruding extension area 4112 of the waterproof structure 400.

With reference to FIG. 14, the waterproof member 430 according to the embodiment may be disposed to surround the protruding extension area 4112. The waterproof member 430 may surround the protruding extension area 4112 and be at least partially in contact with the decoration part 510, the first housing 520, and the housing bonding member 530. For example, the waterproof member 430 may be in contact with the decoration part 510 at one side of the waterproof member 430 and be in contact with the first housing 520 at the other side of the waterproof member 430. In addition, at least a part of the waterproof member 430 may be in contact with one surface of the housing bonding member 530.

In the embodiment, the waterproof member 430 may be in contact with the decoration part extension area 512 of the decoration part 510 positioned in one direction of the waterproof member 430. For example, the waterproof member 430 may be in contact with the decoration part extension area 512 positioned in the positive z-axis direction based on the waterproof member 430.

In the embodiment, the waterproof member 430 may be positioned to be spaced apart from the decoration part extension area 512 of the decoration part 510 positioned in one direction (e.g., the z-axis direction) of the waterproof member 430. For example, the arrangement of the waterproof member 430 may not be limited to the shape illustrated in FIG. 14 in which the waterproof member 430 is in contact with the decoration part extension area 512. The arrangement of the waterproof member 430 may have a shape in which the waterproof member 430 is positioned to be spaced apart from the decoration part extension area 512 by a predetermined distance.

With reference to FIG. 14, at least a part of the cross-section of the protruding extension area 4112 includes the bent shape based on an x-z plane. However, this configuration is provided for illustrative purposes only. The cross-section of the protruding extension area 4112 may not be limited thereto.

In the embodiment, in the decoration part 510, at least a part of the decoration part 510 may be surrounded by the decoration part 510 and a second housing 540 in one axial direction of the decoration part 510 and surrounded by the decoration part 510 and the first housing 520 in the x-axis direction (e.g., the direction perpendicular to the y-axis direction and the z-axis direction (see FIG. 13)).

In the embodiment, an inflow space 545 may be a space at least partially connected to the outside. For example, the decoration part 510 and the second housing 540 may be disposed to be kept spaced apart from each other at a predetermined interval even in the area in which the decoration part 510 and the second housing 540 are positioned to be closest to each other, and the inflow space 545 may be connected to the outside through the interval between the decoration part 510 and the second housing 540.

In the embodiment, the inflow space 545 may be a passageway through which water may move. For example, water may move through at least a part of the inflow space 545 (e.g., the interval between the decoration part 510 and the second housing 540).

In the embodiment, the housing bonding member 530 may be disposed on one surface of the second housing 540. For example, the housing bonding member 530 may be disposed on a surface of the second housing 540 directed in the direction perpendicular to the positive z-axis direction.

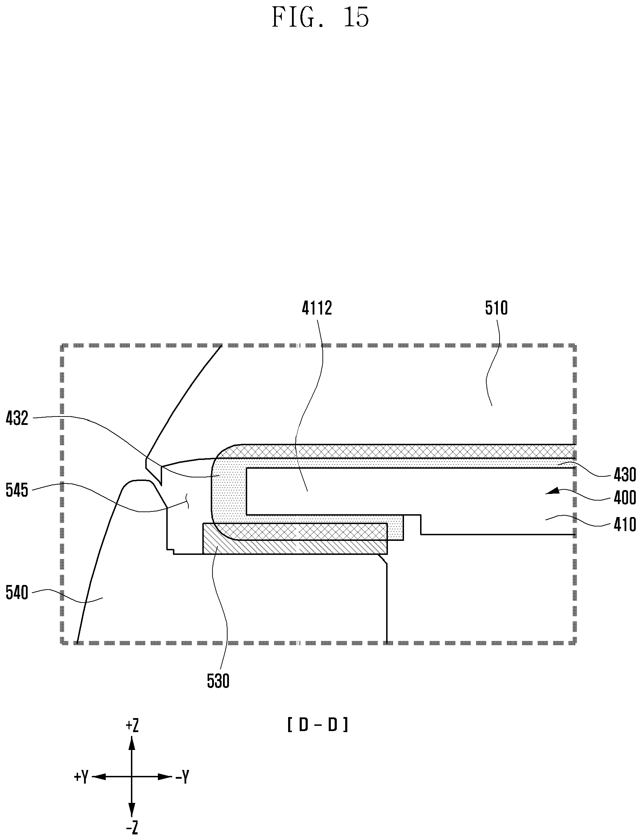

In the embodiment, the protruding extension area 4112 of the waterproof structure 400 may extend in the longitudinal direction of the waterproof structure 400. FIG. 15 illustrates that the protruding extension area 4112 extends in the y-axis direction. However, in case that the longitudinal direction of the waterproof structure 400 extends in the x-axis direction, the protruding extension area 4112 may extend in the x-axis direction.

In the embodiment, the decoration part 510 and the housing bonding member 530 may be positioned to be spaced apart from at least a part of the waterproof structure 400. For example, the decoration part 510 may be positioned to be spaced apart from the protruding extension area 4112 of the waterproof structure 400 in the positive z-axis direction, and the housing bonding member 530 may be positioned to be spaced apart from the protruding extension area 4112 of the waterproof structure 400 in the negative z-axis direction.

In the embodiment, the waterproof member 430 may be disposed to surround the protruding extension area 4112. For example, the waterproof extension area 432 of the waterproof member 430 may be disposed to surround the protruding extension area 4112.

In the embodiment, the waterproof member 430 may be in contact with at least a part of the decoration part 510 and at least a part of the housing bonding member 530. For example, the waterproof member 430 may be in contact with the decoration part 510 in the positive z-axis direction based on the waterproof member 430 and be in contact with the second housing 540 in the negative z-axis direction based on the waterproof member 430.

In the embodiment, the waterproof member 430 may prevent or reduce a situation in which water moving through the inflow space 545 is introduced into the electronic device 200 (see FIG. 2).

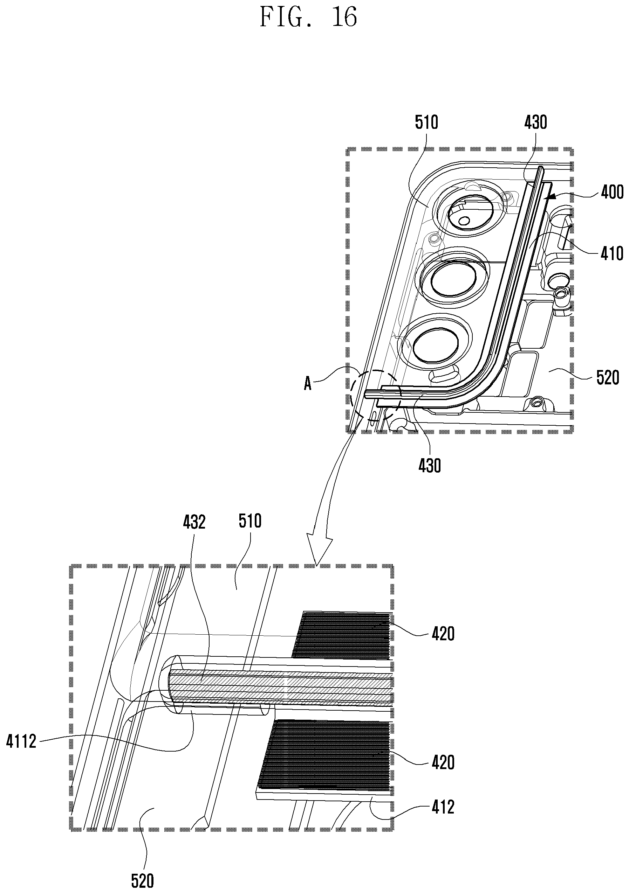

FIG. 16 is a view illustrating the waterproof structure 400 and the waterproof extension area 432 disposed on the decoration part 510 and the first housing 520 according to the embodiment of the present disclosure.

With reference to FIG. 16, the waterproof structure 400 may be disposed to be in contact with at least a part of the decoration part 510 and at least a part of the first housing 520. For example, the waterproof structure 400 may be disposed to be bonded to at least a part of the decoration part 510 and at least a part of the first housing 520 by means of the bonding member 420.

In the embodiment, the bonding member 420 may be disposed in the flat surface area 412 of the plate 410 included in the waterproof structure 400. The bonding member 420 may be bonded to the decoration part 510 and the first housing 520 on one surface of the bonding member 420 and bonded to the flat surface area 412 of the plate 410 on the other surface of the bonding member 420.

In the embodiment, at least a part of the waterproof structure 400 may be disposed between the decoration part 510 and the first housing 520. For example, the decoration part 510 may be disposed at one side based on the waterproof member 430 of the waterproof structure 400, and the first housing 520 may be disposed at the other side based on the waterproof member 430 of the waterproof structure 400.

Area A illustrated in FIG. 16 is an enlarged area of the distal end of the waterproof structure 400. With reference to area A, the areas in which the distal ends of the waterproof structure 400 are positioned may be areas of the periphery of the decoration part 510 and the periphery of the first housing 520 where the decoration part 510 and the first housing 520 are disposed adjacent to each other.

In the embodiment, the waterproof extension area 432 of the waterproof structure 400 may be disposed to extend toward the outer periphery of the decoration part 510 and the outer periphery of the first housing 520 in the direction in which the waterproof structure 400 extends. The waterproof extension area 432 may be disposed to surround the protruding extension area 4112 formed on the plate 410.

In the embodiment, the protruding extension area 4112 and the waterproof extension area 432 of the waterproof structure 400 may further extend toward the outer periphery of the decoration part 510 and the outer periphery of the first housing 520 than the flat surface area 412 of the plate 410.

An electronic device according to an embodiment of the disclosure may be one of various types of electronic devices. The electronic device may include, for example, a portable communication device (e.g., a smartphone), a computer device, a portable multimedia device, a portable medical device, a camera, a wearable device, or a home appliance. The electronic device according to the embodiment of the present disclosure is not limited to the above-mentioned devices.

The embodiments of the present disclosure and the terms used in the embodiments are not intended to limit the technical features disclosed in the present disclosure to the particular embodiments and should be understood as including various alterations, equivalents, or alternatives of the corresponding embodiments. In connection with the description of the drawings, the same or similar reference numerals may be used for the similar components. A singular form of a noun corresponding to an item may include one or more of the items, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). If an element (e.g., a first element) is referred to, with or without the term "operatively" or "communicatively," as "coupled with," "coupled to," "connected with," or "connected to" another element (e.g., a second element), it means that the element may be coupled with the other element directly (e.g., wiredly), wirelessly, or via a third element.

The term "module" used in the embodiments of the present disclosure may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to the embodiment, the module may be implemented in a form of an application-specific integrated circuit (ASIC).

The embodiments as set forth herein may be implemented as software (e.g., the program 140) including one or more instructions that are stored in a storage medium (e.g., an internal memory 136 or an external memory 138) that is readable by a machine (e.g., the electronic device 101). For example, a processor (e.g., the processor 120) of the machine (e.g., the electronic device 101) may invoke at least one of the one or more instructions stored in the storage medium, and execute the instructions. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to the embodiment, a method according to the embodiment of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PLAYSTORETM), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to the embodiment, each constituent element (e.g., module or program), among the above-mentioned constituent elements, may include a single object or a plurality of objects, and some of the plurality of objects may be disposed separately in different constituent elements. According to the embodiment, one or more constituent elements, among the above-mentioned constituent elements, or operations may be omitted, or one or more other constituent elements or operations may be added. Alternatively or additionally, a plurality of components (e.g., modules or programs) may be integrated into a single component. In such a case, the integrated component may perform one or more functions of each of the plurality of components in the same or similar manner as they are performed by a corresponding one of the plurality of components before the integration. According to the embodiment, operations performed by the module, the program, or another component may be carried out sequentially, in parallel, repeatedly, or heuristically, or one or more of the operations may be executed in a different order or omitted, or one or more other operations may be added.

## Claims

1. An electronic device (200) comprising:
a first housing (220, 520);
a decoration part (210, 510) disposed to be at least partially spaced apart from the first housing;
a second housing (250, 540);
a housing bonding member (240, 530) extending along a periphery of the second housing and having one surface on which the first housing and the decoration part are disposed, and the other surface on which the second housing is disposed;
a plate (410) disposed on at least a portion of the first housing and the decoration part, the plate comprising a flat surface area (412) and a protruding area (411) protruding from the flat surface area to be disposed in a space between the first housing and the decoration part; and
a waterproof member (430) disposed along the protruding area and configured to seal at least a part of the space.

2. The electronic device of claim 1, wherein the plate extends in a longitudinal direction of the electronic device, is bent at least partially, and then extends in a width direction of the electronic device.

3. The electronic device of claim 2, wherein the flat surface area of the plate comprises a flat surface bent area (4121) that extends in the longitudinal direction of the electronic device, is bent at least partially, and extends in the width direction of the electronic device, and
wherein at least a part of the flat surface bent area is formed as a curved surface.

4. The electronic device of claim 1, further comprising a bonding member (420, 420-1, 420-2) disposed in at least a part of the flat surface area and configured to bond at least a part of the plate to the decoration part and the first housing.

5. The electronic device of claim 1, further comprising two bonding members, one bonding member of the two bonding members being disposed along the flat surface area extending to one side of the protruding area, and the remaining bonding member being disposed along the flat surface area extending to the other side of the protruding area.

6. The electronic device of claim 4, wherein a thickness of the bonding member is smaller than a thickness of the housing bonding member.

7. The electronic device of claim 1, wherein at least a portion of the first housing comprises an installation area (221) in which the decoration part is disposed, and the plate extends to correspond to a periphery of the installation area of the first housing.

8. The electronic device of claim 1, wherein a thickness of the flat surface area of the plate is 0.05 mm to 0.3 mm.

9. The electronic device of claim 1, wherein the protruding area of the plate is formed as at least a part of the plate is bent in a height direction of the electronic device.

10. The electronic device of claim 1, wherein the decoration part comprises a decoration part extension area (512) formed as at least a part of the decoration part extends in one direction of the decoration part, and
wherein the decoration part extension area is positioned to be spaced apart from the protruding area of the plate and at least a part of the first housing in a height direction of the electronic device.

11. The electronic device of claim 10, wherein the waterproof member is in contact with the decoration part at one side and is in contact with the first housing at the other side.

12. The electronic device of claim 1, wherein the protruding area of the plate comprises a protruding extension area (4112) further extending in a longitudinal direction of the plate than a distal end of the flat surface area of the plate.

13. The electronic device of claim 12, wherein the waterproof member comprises a waterproof extension area (432) disposed along the protruding extension area.

14. The electronic device of claim 13, wherein the waterproof member is disposed to overlap at least a part of the housing bonding member in one area of the waterproof member that further extends in the longitudinal direction of the plate than the flat surface area.

15. The electronic device of claim 1, wherein at least a part of the waterproof member is disposed to surround the protruding area and cover at least a part of the flat surface area.

## Patentansprüche

1. Elektronische Vorrichtung (200), die Folgendes umfasst:
ein erstes Gehäuse (220, 520);
einen Dekorationsteil (210, 510), der so angeordnet ist, dass er zumindest teilweise von dem ersten Gehäuse beabstandet ist;
ein zweites Gehäuse (250, 540);
ein Gehäuseverbindungselement (240, 530), das sich entlang eines Umfangs des zweiten Gehäuses erstreckt und eine Oberfläche, auf der das erste Gehäuse und der Dekorationsteil angeordnet sind, und die andere Oberfläche aufweist, auf der das zweite Gehäuse angeordnet ist;
eine Platte (410), die auf mindestens einem Teil des ersten Gehäuses und des Dekorationsteils angeordnet ist, wobei die Platte eine ebene Fläche (412) und einen vorspringenden Bereich (411) umfasst, der von der ebenen Fläche so vorspringt, dass er in einem Raum zwischen dem ersten Gehäuse und dem Dekorationsteil angeordnet ist; und
ein wasserdichtes Element (430), das entlang des vorspringenden Bereichs angeordnet und so konfiguriert ist, dass es mindestens einen Teil des Raumes abdichtet.

2. Elektronische Vorrichtung nach Anspruch 1, wobei sich die Platte in Längsrichtung der elektronischen Vorrichtung erstreckt, zumindest teilweise gebogen ist und sich dann in Breitenrichtung der elektronischen Vorrichtung erstreckt.

3. Elektronische Vorrichtung nach Anspruch 2, wobei die ebene Fläche der Platte eine ebene gebogene Fläche (4121) umfasst, die sich in Längsrichtung der elektronischen Vorrichtung erstreckt, zumindest teilweise gebogen ist und sich in Breitenrichtung der elektronischen Vorrichtung erstreckt, und
wobei mindestens ein Teil der ebenen gebogenen Fläche als gekrümmte Fläche ausgebildet ist.

4. Elektronische Vorrichtung nach Anspruch 1, die ferner ein Verbindungselement (420, 420-1, 420-2) umfasst, das in mindestens einem Teil der ebenen Fläche angeordnet und so konfiguriert ist, dass es mindestens einen Teil der Platte mit dem Dekorationsteil und dem ersten Gehäuse verbindet.

5. Elektronische Vorrichtung nach Anspruch 1, die ferner zwei Verbindungselemente umfasst, wobei ein Verbindungselement der zwei Verbindungselemente entlang der ebenen Fläche angeordnet ist, die sich zu einer Seite des vorspringenden Bereichs erstreckt, und das verbleibende Verbindungselement entlang der ebenen Fläche angeordnet ist, die sich zu der anderen Seite des vorspringenden Bereichs erstreckt.

6. Elektronische Vorrichtung nach Anspruch 4, wobei eine Dicke des Verbindungselements kleiner als eine Dicke des Gehäuseverbindungselements ist.

7. Elektronische Vorrichtung nach Anspruch 1, wobei mindestens ein Teil des ersten Gehäuses einen Installationsbereich (221) umfasst, in dem der Dekorationsteil angeordnet ist, und sich die Platte so erstreckt, dass sie einem Umfang des Installationsbereichs des ersten Gehäuses entspricht.

8. Elektronische Vorrichtung nach Anspruch 1, wobei eine Dicke der ebenen Fläche der Platte 0,05 mm bis 0,3 mm beträgt.

9. Elektronische Vorrichtung nach Anspruch 1, wobei der vorspringende Bereich der Platte dadurch gebildet wird, dass mindestens ein Teil der Platte in Höhenrichtung der elektronischen Vorrichtung gebogen ist.

10. Elektronische Vorrichtung nach Anspruch 1, wobei der Dekorationsteil einen Dekorationsteil-Verlängerungsbereich (512) umfasst, der dadurch gebildet wird, dass sich mindestens ein Teil des Dekorationsteils in eine Richtung des Dekorationsteils erstreckt, und
wobei der Dekorationsteil-Verlängerungsbereich so angeordnet ist, dass er von dem vorspringenden Bereich der Platte und mindestens einem Teil des ersten Gehäuses in Höhenrichtung der elektronischen Vorrichtung beabstandet ist.

11. Elektronische Vorrichtung nach Anspruch 10, wobei das wasserdichte Element auf einer Seite in Kontakt mit dem Dekorationsteil steht und auf der anderen Seite in Kontakt mit dem ersten Gehäuse steht.

12. Elektronische Vorrichtung nach Anspruch 1, wobei der vorspringende Bereich der Platte einen vorspringenden Verlängerungsbereich (4112) umfasst, der sich weiter in Längsrichtung der Platte als ein distales Ende der ebenen Fläche der Platte erstreckt.

13. Elektronische Vorrichtung nach Anspruch 12, wobei das wasserdichte Element einen wasserdichten Verlängerungsbereich (432) umfasst, der entlang des vorspringenden Verlängerungsbereichs angeordnet ist.

14. Elektronische Vorrichtung nach Anspruch 13, wobei das wasserdichte Element so angeordnet ist, dass es mindestens einen Teil des Gehäuseverbindungselements in einem Bereich des wasserdichten Elements überlappt, der sich weiter in Längsrichtung der Platte als die ebene Fläche erstreckt.

15. Elektronische Vorrichtung nach Anspruch 1, wobei mindestens ein Teil des wasserdichten Elements so angeordnet ist, dass er den vorspringenden Bereich umschließt und mindestens einen Teil der ebenen Fläche abdeckt.

## Revendications

1. Dispositif électronique (200) comprenant :
un premier boîtier (220, 520) ;
une partie décorative (210, 510) disposée de manière à être au moins partiellement espacée du premier boîtier ;
un deuxième boîtier (250, 540) ;
un élément de liaison de boîtiers (240, 530) s'étendant le long d'une périphérie du deuxième boîtier et ayant une surface sur laquelle sont disposés le premier boîtier et la partie décorative, et l'autre surface sur laquelle est disposé le deuxième boîtier ;
une plaque (410) disposée sur au moins une partie du premier boîtier et de la partie décorative, la plaque comprenant une zone de surface plane (412) et une zone saillante (411) faisant saillie à partir de la zone de surface plane pour être disposée dans un espace entre le premier boîtier et la partie décorative ; et
un élément étanche (430) disposé le long de la zone saillante et configuré pour sceller au moins une partie de l'espace.

2. Dispositif électronique selon la revendication 1, où la plaque s'étend dans une direction longitudinale du dispositif électronique, est courbée au moins partiellement, puis s'étend dans une direction de largeur du dispositif électronique.

3. Dispositif électronique selon la revendication 2, où la zone de surface plane de la plaque comprend une zone de surface plane courbée (4121) qui s'étend dans la direction longitudinale du dispositif électronique, est courbée au moins partiellement et s'étend dans la direction de largeur du dispositif électronique, et
où au moins une partie de la zone de surface plane courbée est formée comme une surface incurvée.

4. Dispositif électronique selon la revendication 1, comprenant en outre un élément de liaison (420, 420-1, 420-2) disposé dans au moins une partie de la zone de surface plane et configuré pour relier au moins une partie de la plaque à la partie décorative et au premier boîtier.

5. Dispositif électronique selon la revendication 1, comprenant en outre deux éléments de liaison, un élément de liaison des deux éléments de liaison étant disposé le long de la zone de surface plane s'étendant vers un côté de la zone saillante, et l'élément de liaison restant étant disposé le long de la zone de surface plane s'étendant vers l'autre côté de la zone saillante.

6. Dispositif électronique selon la revendication 4, où une épaisseur de l'élément de liaison est inférieure à une épaisseur de l'élément de liaison de boîtier.

7. Dispositif électronique selon la revendication 1, où au moins une partie du premier boîtier comprend une zone d'installation (221) dans laquelle la partie décorative est disposée, et la plaque s'étend pour correspondre à une périphérie de la zone d'installation du premier boîtier.

8. Dispositif électronique selon la revendication 1, où une épaisseur de la zone de surface plane de la plaque est de 0,05 mm à 0,3 mm.

9. Dispositif électronique selon la revendication 1, où la zone saillante de la plaque est formée de telle sorte qu'au moins une partie de la plaque est courbée dans le sens de la hauteur du dispositif électronique.

10. Dispositif électronique selon la revendication 1, où la partie décorative comprend une zone d'extension de partie décorative (512) formée de telle sorte qu'au moins une partie de la partie décorative s'étend dans une direction de la partie décorative, et
où la zone d'extension de partie décorative est positionnée de manière à être espacée de la zone saillante de la plaque et d'au moins une partie du premier boîtier dans le sens de la hauteur du dispositif électronique.

11. Dispositif électronique selon la revendication 10, où l'élément étanche est en contact avec la partie décorative d'un côté et est en contact avec le premier boîtier de l'autre côté.

12. Dispositif électronique selon la revendication 1, où la zone saillante de la plaque comprend une zone d'extension saillante (4112) s'étendant davantage dans une direction longitudinale de la plaque qu'une extrémité distale de la zone de surface plane de la plaque.

13. Dispositif électronique selon la revendication 12, où l'élément étanche comprend une zone d'extension étanche (432) disposée le long de la zone d'extension saillante.

14. Dispositif électronique selon la revendication 13, où l'élément étanche est disposé de manière à chevaucher au moins une partie de l'élément de liaison de boîtier dans une zone de l'élément étanche qui s'étend davantage dans la direction longitudinale de la plaque que la zone de surface plane.

15. Dispositif électronique selon la revendication 1, où au moins une partie de l'élément étanche est disposée de manière à entourer la zone saillante et à recouvrir au moins une partie de la zone de surface plane.
